# EUROPÄISCHE PATENTANMELDUNG

(11) **EP 3 998 842 A1**
(43) Veröffentlichungstag der Anmeldung: **18.05.2022**
(21) Anmeldenummer: 21208247.3
(22) Anmeldetag: 24.09.2019
(51) Int. Cl.: H05K 1/02, H05K 1/03, H01L 23/373, H05K 3/06, C04B 37/02

(54) **TRÄGERSUBSTRAT FÜR ELEKTRISCHE, INSBESONDERE ELEKTRONISCHE BAUTEILE UND VERFAHREN ZUM HERSTELLEN EINES TRÄGERSUBSTRATS**

(30) Priorität: 26.09.2018 DE 102018123681
(62) Teilanmeldung aus: 19779787.1
(71) Anmelder: Rogers Germany GmbH, 92676 Eschenbach (DE)
(72) Erfinder: Britting, Stefan, 91220 Schnaittach (DE); Meyer, Andreas, 95469 Speichersdorf (DE); Tang, Xinhe, 93173 Wenzenbach (DE); Adler, Andrea, 92676 Eschenbach (DE)
(74) Vertreter: Müller Schupfner & Partner Patent- und Rechtsanwaltspartnerschaft mbB

(57) **Zusammenfassung**

Trägersubstrat (1), umfassend
eine Isolationsschicht (11) und eine Metallschicht (12),
wobei die Metallschicht (12) in einer parallel zur Haupterstreckungsebene (HSE) verlaufenden Primärrichtung (P) zumindest bereichsweise mit einem Flankenverlauf (2), insbesondere Ätzflankenverlauf, abschließt,
wobei in Primärrichtung (P) gesehen sich der Flankenverlauf (2) von einer ersten Kante (15) an einer Oberseite (31) der Metallschicht (12), die der Isolationsschicht (11) abgewandt ist, bis zu einer zweiten Kante (16) an einer Unterseite (32) der Metallschicht (12), die der Isolationsschicht (11) zugewandt ist, erstreckt, dadurch gekennzeichnet, dass der Flankenverlauf (2) in Primärrichtung (P) gesehen ein lokales Maximum (21) und ein lokales Minimum (22) aufweist.

## Beschreibung

Die vorliegende Erfindung betrifft ein Trägersubstrat für elektrische, insbesondere elektronische, Bauteile und ein Verfahren zum Herstellen eines Trägersubstrats.

Trägersubstrate sind beispielsweise als Leiterplatten oder Platinen aus dem Stand der Technik hinlänglich bekannt, beispielsweise aus der DE 10 2013 104 739 A1, DE 19 927 046 B4 und DE 10 2009 033 029 A1. Typischerweise werden auf einer Bauteilseite des Trägersubstrats Anschlussflächen für elektrische Bauteile und Leiterbahnen angeordnet, wobei die elektrischen Bauteile und die Leiterbahnen zu elektrischen Schaltkreisen zusammenschaltbar sind. Wesentliche Bestandteile der Trägersubstrate sind eine Isolationsschicht, die bevorzugt aus einer Keramik gefertigt ist, und eine an die Isolationsschicht angebundene Metallschicht. Wegen ihren vergleichsweise hohen Isolationsfestigkeiten haben sich aus Keramik gefertigte Isolationsschichten als besonders vorteilhaft erwiesen. Durch eine Strukturierung der Metallschicht können sodann Leiterbahnen und/oder Anschlussflächen für die elektrischen Bauteile realisiert werden.

Grundsätzlich ist neben einem niedrigen Wärmewiderstand auch eine hohe Temperaturwechselbeständigkeit wünschenswert, die zur Langlebigkeit des entsprechenden Trägersubstrats beiträgt. Dabei hat es sich beispielswiese als vorteilhaft erwiesen, Aussparungen in den Randbereich der Metallschicht einzulassen, um mechanische Spannungen abzubauen und das Bruchverhalten von Großkarten zu verbessern. Insbesondere die Verbesserung des Bruchverhaltens von Großkarten wird in der Druckschrift EP 1 061 783 A2 offenbart. Dies führt allerdings in der Regel zu einer Reduktion einer effektiven Nutzfläche für die Anbindung von elektrischen oder elektronischen Bauteilen.

Ausgehend von diesem Hintergrund macht es sich die vorliegende Erfindung zur Aufgabe, die aus dem Stand der Technik bekannten Trägersubstrate zu verbessern, insbesondere hinsichtlich ihrer Temperaturwechselbeständigkeit, einer effektiven Größe der Nutzfläche und/oder eines Bruchverhaltens von Großkarten.

Diese Aufgabe wird gelöst durch ein Trägersubstrat gemäß Anspruch 1 und ein Verfahren gemäß Anspruch 10. Weitere Vorteile und Merkmale der Erfindung ergeben sich aus den Unteransprüchen sowie der Beschreibung und den beigefügten Figuren.

Erfindungsgemäß ist ein Trägersubstrat, insbesondere ein Metall-Keramik-Substrat, vorgesehen, das eine Isolationsschicht, vorzugsweise eine Keramikschicht, und eine Metallschicht umfasst, wobei die Metallschicht in einer parallel zur Haupterstreckungsebene verlaufenden Primärrichtung am äußersten Umfang zumindest bereichsweise mit einem Flankenverlauf, insbesondere Ätzflankenverlauf, abschließt, wobei sich in Primärrichtung gesehen der Flankenverlauf von einer ersten Kante an einer Oberseite der Metallschicht, die der Isolationsschicht abgewandt ist, bis zu einer zweiten Kante an einer Unterseite der Metallschicht, die der Isolationsschicht zugewandt ist, erstreckt und wobei der Flankenverlauf in Primärrichtung gesehen, insbesondere bezogen auf die der Metallschicht zugewandte Oberfläche der Isolationsschicht, mindestens ein lokales Maximum und mindestens ein lokales Minimum aufweist.

Gegenüber dem Stand der Technik weist das erfindungsgemäße Trägersubstrat einen Flankenverlauf mit mindestens einem lokalen Maximum und mindestens einem lokalem Minimum auf, d. h. zwischen der ersten Kante und der zweiten Kante ist ein lokales Maximum und ein lokales Minimum angeordnet. Die Begriffe "Maximum" bzw. "Minimum" bedeuten im Sinne der Erfindung die Höhe oder Dicke der Metallschicht an dieser Stelle, bezogen auf die der Metallschicht zugewandten Oberfläche der Isolationsschicht. Mit anderen Worten: es bildet sich eine Wölbung bzw. Ausbeulung, beispielsweise in Form eines Vorhügels oder Vorerhebung, im Flankenverlauf aus. Es hat sich in vorteilhafter Weise herausgestellt, dass sich mit einem Flankenverlauf, der mindestens ein lokales Maximum und ein lokales Minimum aufweist, eine Temperaturwechselbeständigkeit signifikant verbessern lässt. Insbesondere erstreckt sich die Primärrichtung nach außen, d. h. von einem als Nutzfläche von der Metallschicht bereitgestellten Bereich zu einem metallfreien Bereich auf dem Trägersubstrat. Die Verbesserung der Temperaturwechselbeständigkeit durch den Flankenverlauf mit dem lokalem Maximum und dem lokalen Minimum gestattet es zudem in vorteilhafter Weise, auf eine Materialschwächung, beispielsweise in Form von kuppelförmigen Aushöhlungen, im Randbereich zu verzichten, wodurch die effektive Nutzfläche auf der Oberseite der Metallschicht vergrößert werden kann. Der Flankenverlauf bildet sich dabei als Außenseite der Metallschicht in einem senkrecht zur Haupterstreckungsebene und parallel zur Primärrichtung verlaufenden Querschnitt bzw. einer entsprechenden Schnittansicht aus. Vorzugsweise ist die Anzahl der lokalen Maxima und lokalen Minima jeweils kleiner als 5. Besonders bevorzugt gibt es genau ein lokales Maximum und ein lokales Minimum. Der Flankenverlauf ist bevorzugt wellenförmig.

Vorzugsweise bildet sich ein Wendepunkt bzw. ein Umkehrpunkt zwischen der ersten Kante und der zweiten Kante aus. Vorzugsweise ist das lokale Maximum zwischen dem Umkehrpunkt bzw. Wendepunkt und der zweiten Kante angeordnet und das lokale Minimum zwischen der ersten Kante und dem Umkehrpunkt bzw. Wendepunkt. Beispielsweise lässt sich der Flankenverlauf zumindest bereichsweise über ein Polynom mindestens dritten Grades beschreiben. Dabei ist es vorstellbar, dass der Flankenverlauf entlang eines Umfangs der Metallschicht, d. h. entlang einer geschlossenen Kurve innerhalb der Haupterstreckungsebene am äußersten Umfang der Metallschicht, zu mehr als 50 %, bevorzugt zu mehr als 75 % und besonders bevorzugt vollständig mit einem lokalen Maximum und einem lokalen Minimum ausgestaltet ist. Als lokales Maximum / Minimum versteht der Fachmann insbesondere einen Bereich, in dem in der Umgebung der Flankenverlauf nicht größer / nicht kleiner ist als im lokalen Maximum / Minimum. Dabei kann der Flankenverlauf in Form von globalen Maxima bzw. Minima durchaus größere bzw. kleinere Werte als das lokale Maximum bzw. Minimum annehmen. Beispielsweise nimmt der Flankenverlauf an der ersten Kante ein globales Maximum an, während an der zweiten Kante ein globales Minimum angenommen wird. Weiterhin ist es vorzugsweise vorgesehen, dass sich der Kantenverlauf kontinuierlich, d. h. im Wesentlich stufenlos entlang der Primärrichtung erstreckt.

Vorzugsweise weist die Isolationsschicht Al₂O₃, Si₃N₄, AlN, ZTA (Zirkonia toughened Alumina), MgO, BeO, SiC oder hochdichtes MgO (> 90% der theoretischen Dichte), TSZ (tetragonal stabilisiertes Zirkonoxid) oder ZTA als Material für die Keramik auf. Es ist dabei auch vorstellbar, dass die Isolationsschicht als Verbund- bzw. Hybridkeramik ausgebildet ist, bei der zur Kombination verschiedener gewünschter Eigenschaften mehrere Isolationsschichten, die sich jeweils in Hinblick auf ihre materielle Zusammensetzung unterscheiden, übereinander angeordnet und zu einer Isolationsschicht zusammengefügt sind. Es ist sogar vorstellbar, dass die Isolationsschicht, beispielsweise zur Bildung eines IMB, aus einem organischen Material, z.B. einem Harz, gefertigt ist. Als Materialien für die Metallschicht sind Kupfer, Aluminium, Molybdän und/oder deren Legierungen sowie Laminate, wie CuW, CuMo, CuAl, AlCu und/oder CuCu, insbesondere eine Kupfersandwichstruktur mit einer ersten Kupferschicht und einer zweiten Kupferschicht, wobei sich eine Korngröße in der ersten Kupferschicht von der zweiten Kupferschicht unterscheidet, vorstellbar.

Vorzugsweise wird der Flankenverlauf durch einen Ätzschritt hergestellt. Alternativ oder ergänzend ist es vorstellbar, dass der Flankenverlauf durch Fräsen und/oder Laserablation hergestellt wird. Darüber hinaus ist es vorzugsweise vorgesehen, dass das Trägersubstrat neben der Metallschicht und der Isolationsschicht mindestens eine weitere Metallschicht und/oder eine weitere Isolationsschicht aufweist. Dabei ist das Trägersubstrat vorzugsweise in Sandwichbauweise zusammengesetzt und die Isolationsschicht ist zwischen der Metallschicht und der weiteren Metallschicht angeordnet. Bevorzugt ist es vorgesehen, dass die weitere Metallschicht frei ist von Strukturierungen. D. h. an der der Metallschicht gegenüberliegenden Seite der Keramikschicht ist die weitere Metallschicht durchgehend ausgestaltet. In diesem Fall bildet die weitere Metallschicht eine Rückseitenmetallisierung aus, die es beispielsweise gestattet, eine vergleichsweise dünne Isolationsschicht von weniger als 800 µm, zu verwenden.

Weiterhin ist es vorstellbar, dass die zweite Kante entlang einer Umlaufrichtung (, d. h. entlang einer dem generellen Verlauf der ersten Kante und der zweiten Kante um die Nutzfläche herum folgenden Richtung) gesehen die Anbindungsfläche in der Haupterstreckungsebene begrenzt und dabei in Umlaufrichtung einen mäanderförmigen, briefmarkenrandförmigen und/oder einen sägezahnförmigen Verlauf aufweist, wobei sich insbesondere der mäanderförmige, briefmarkenrandförmige und/oder der sägezahnförmige Verlauf über die gesamte zweite Kante der Metallschicht erstreckt. Vorstellbar ist auch, dass sich der mäanderförmige, briefmarkenrandförmige und/oder sägezahnförmige Verlauf der Metallschicht nur über einen Teilbereich der zweiten Kante der Metallschicht erstreckt bzw. mehrere Teilbereiche in Umlaufrichtung gesehen zueinander beabstandet aneinander anschließen. Durch die Ausbildung eines strukturierten und/oder modulierten Verlaufs der zweiten Kante wird dessen Oberflächenvergrößerung so ausgelegt, dass im Wesentlichen unabhängig vom Ort des Auftretens einer mechanischen Spannung diese vorteilhaft verteilt werden kann. Vorzugsweise ist die erste Kante analog moduliert. Der Flankenverlauf in Umlaufrichtung kann aber auch unregelmäßige Rücksprünge aufweisen, d. h. z. B. kleine und größere Aussparungen, die gemischt oder abwechselnd zueinander angeordnet sind, oder die wellenlinienförmig, rechteckförmig, parallellogrammförmig oder zackig ausgebildet sind.

Insbesondere ist es vorgesehen, dass sich die Anbindungsfläche nicht über die gesamte Länge der Isolationsschicht entlang der Primärrichtung erstreckt. Mit anderen Worten: die Isolationsschicht steht in Richtung der Haupterstreckungsebene gegenüber der Metallschicht, insbesondere gegenüber der zweiten Kante, vor.

Vorzugsweise ist die Metallschicht strukturiert und die erste und zweite Kante entsteht in Folge einer Strukturierungsmaßnahme, z. B. einem Ätzen oder einem Oberflächenfräsen von Isolationsgräben. Ferner ist es vorstellbar, dass die Metallschicht in einem Randbereich, der sich an der ersten Kante in Richtung eines Zentrums der Metallschicht bzw. in Richtung der Nutzfläche, d. h. nach innen, erstreckt, eine Materialschwächung aufweist. Der Randbereich liegt somit in Primärrichtung gesehen bezogen auf die erste Kante dem Flankenverlauf gegenüber. Unter einer Materialschwächung ist insbesondere eine Variation bzw. Modulation in der Metallschichtdicke zu verstehen. Beispielsweise ist als Materialschwächung eine kuppelförmige Aussparung an der Oberseite der Metallschicht zu verstehen. Vorzugsweise beträgt ein Verhältnis einer Erstreckung des Randbereichs zu einer in dieselbe Richtung bemessenen Gesamtlänge der Metallschicht einen Wert von weniger als 0,25, bevorzugt weniger als 0,15 und besonders bevorzugt weniger als 0,1. Ferner ist es vorstellbar, dass in Primärrichtung gesehen an der Metallschicht ein dem Randbereich gegenüberliegender weiterer Randbereich ausgebildet ist (das beschriebene Verhältnis berücksichtigt dann die Erstreckung des Randbereichs und des weiteren Randbereichs). Vorzugsweise ist es vorgesehen, dass die Dimensionierung des Randbereichs, d. h. insbesondere das Verhältnis der Erstreckung des Randbereichs in Primärrichtung gesehen zur in dieselbe Richtung gemessenen Gesamtlänge der Metallschicht, abhängt von der ersten Dicke der Metallschicht. Beispielsweise ist für Metallschichten, deren erste Dicke größer ist als 150 µm - beispielsweise zwischen 0,4 und 2,5 mm liegt -, das Verhältnis der Erstreckung des Randbereichs in Primärrichtung gesehen zur in dieselbe Richtung gemessenen Gesamtlänge der Metallschicht kleiner als 0,35, bevorzugt kleiner als 0,25 und besonders bevorzugt kleiner als 0,18. Dabei bemisst sich die Erstreckung bzw. die Gesamtlänge insbesondere in einer senkrecht zum Verlauf der ersten Kante orientierten Richtung. Insbesondere beginnt die Messung der Erstreckung mit der ersten Kante und ist auf einen Zentralbereich der Metallschicht gerichtet.

Weiterhin ist es bevorzugt vorgesehen, dass die zweite Kante umlaufend, insbesondere zumindest teilweise oder vollständig, mit einem Füllmaterial bedeckt ist.

Dabei ist das Füllmaterial dazu geeignet, die Rissbildung an der Kante zu unterdrücken, d.h. eine Ausdehnung des Risses zu hemmen oder sogar gänzlich zu verhindern. Vorzugsweise umfasst das Füllmaterial ein Kunststoffmaterial, wie Polyimid, Polyamide, Epoxid oder Polyetheretherketon. Es ist dabei auch vorstellbar, dass dem Kunststoffmaterial ein Keramikanteil zugefügt ist. Beispiele für einen solchen Zusatzstoff sind Siliziumnitrid, Aluminiumnitrid, Aluminiumoxid, Bornitrid oder Glas.

Es ist auch vorstellbar, dass dem Kunststoffmaterial Kohlefasern, Glasfasern und/oder Nanofasern beigefügt sind. Vorzugsweise ist es vorgesehen, dass das Füllmaterial hitzebeständig ist, d. h. das Füllmaterial schmilzt nicht bei Temperaturen, die bei der Herstellung des Trägersubstrats nach dem Aufbringen des Füllmaterials und/oder beim Löten auftreten. Weiterhin ist es bevorzugt vorgesehen, dass das Füllmaterial geeignet ist, eine feste und gute Bindung mit der Isolationsschicht, vorzugsweise dem gewählten Keramikmaterial, und der Metallschicht, vorzugsweise dem gewählten Metall, wie Kupfer, einzugehen. Weiterhin ist es vorgesehen, dass der thermische Ausdehnungskoeffizient des Füllmaterials gleich oder größer ist als der thermische Ausdehnungskoeffizient der Isolationsschicht und/oder der Metallschicht. Beispielsweise ist der thermische Ausdehnungskoeffizient des Füllmaterials mehr als dreimal so groß wie der thermische Ausdehnungskoeffizient der Metallschicht.

Gemäß einer bevorzugten Ausführungsform der vorliegenden Erfindung ist es vorgesehen, dass die Metallschicht außerhalb des Flankenverlaufs, insbesondere in einem als Nutzfläche vorgesehenen zentralen Bereich, eine erste Dicke, und im lokalen Maximum eine zweite Dicke aufweist, wobei die zweite Dicke kleiner ist als die erste Dicke. Dadurch wird sichergestellt, dass das lokale Maximum nicht gegenüber der Oberseite der Metallschicht vorsteht. Dabei erstreckt sich das lokale Maximum in Umlaufrichtung wulstartig und bildet gegenüber dem globalen Maximum des Flankenverlaufs, nämlich der ersten Kante, einen Vorläufer in der Erhöhung. Es ist dabei vorstellbar, dass das lokale Maximum Teil eines Plateaus oder einer kuppelförmigen Auswölbung ist. In Umlaufrichtung (d. h. wenn man einer Erstreckungsrichtung der ersten Kante bzw. der zweiten Kante folgt) gesehen erstreckt sich dabei das lokale Maximum über mehr als 50 % des gesamten Umfangs der Metallschicht, bevorzugt über mehr als 75 % der Metallschicht, und besonders bevorzugt vollständig entlang des Umfangs der Metallschicht. Weiterhin ist es vorgesehen, dass die Metallschicht an der ersten Kante die erste Dicke aufweist und insbesondere die erste Dicke einer maximalen Dicke der Metallschicht darstellt.

Vorteilhafterweise ist es vorgesehen, dass ein Verhältnis der zweiten Dicke zur ersten Dicke einen Wert annimmt, der kleiner ist als 0,95, bevorzugt kleiner als 0,9, und besonders bevorzugt kleiner als 0,8. Es hat sich in vorteilhafter Weise herausgestellt, dass das relative Verhältnis der zweiten Dicke zur ersten Dicke vergleichsweise unabhängig gewählt werden kann, um den positiven Effekt auf die Temperaturwechselbeständigkeit zu erzielen, wenn das Verhältnis zumindest kleiner als 0,9 ist. Das heißt, es kann ein vergleichsweise ähnlicher Flankenverlauf gewählt werden für eine große erste Dicke der Metallschicht oder eine kleine erste Dicke der Metallschicht.

Vorteilhafterweise ist es vorgesehen, dass ein Verhältnis der zweiten Dicke zur ersten Dicke einen Wert annimmt, der kleiner ist als 1.

Vorteilhafterweise ist es vorgesehen, dass sich der Flankenverlauf in Primärrichtung gemessen über eine erste Länge zwischen der ersten Kante und der zweiten Kante erstreckt, wobei ein Verhältnis zwischen der ersten Länge zur ersten Dicke einen Wert zwischen 0,5 und 1,9, bevorzugt zwischen 0,6 und 1,7, und besonders bevorzugt zwischen 0,7 und 1,5 annimmt. Dadurch lassen sich vergleichsweise breite Flankenverläufe realisieren. Zum Vergleich: Typischerweise ist das Verhältnis zwischen der ersten Länge zur ersten Dicke kleiner als 0,5. Es hat sich herausgestellt, dass sich diese Verbreiterung des Flankenverlaufs nicht nur positiv auf die Temperaturwechselbeständigkeit auswirkt, sondern zudem auch eine Wärmespreizung unterstützt, insbesondere für Bauteile, die sehr nah an der ersten Kante platziert werden, da diese dann auch den Bereich unterhalb des Flankenverlaufs der Metallschicht zum Wärmetransport mitnutzen können. Ein breiter Flankenverlauf lässt es zudem zu, die Strukturierung mit lokalem Maximum und lokalem Minimum kontrollierter einstellen zu können. Vorzugsweise ist es vorgesehen, dass die zweite Dicke in einem Punkt gemessen wird, der in Primärrichtung gesehen das 2/5-fache der ersten Länge von der zweiten Kante entfernt ist, insbesondere wenn das lokale Maximum durch den Flankenverlauf nicht klar ersichtlich sein sollte.

Vorzugsweise ist es vorgesehen, dass sich der Flankenverlauf von der zweiten Kante an der Unterseite bis zum lokalen Maximum über eine zweite Länge erstreckt, wobei ein Verhältnis zwischen der zweiten Länge zu der ersten Länge einen Wert zwischen 0,2 und 0,7, bevorzugt zwischen 0,25 und 0,6 und besonders bevorzugt zwischen 0,3 und 0,5 annimmt. Mit anderen Worten: es hat sich herausgestellt, dass es besonders vorteilhaft ist, wenn das lokale Maximum, das heißt die lokale Erhebung im Flankenverlauf, von der zweiten Kante aus gesehen in der ersten Hälfte oder, bevorzugt, in einem Bereich zwischen der ersten Hälfte und dem ersten Drittel des Flankenverlaufs angeordnet ist. Damit liegt das lokale Maximum insbesondere am äußersten Rand der Metallschicht und unterstützt so die Temperaturwechselbeständigkeit des gesamten Trägersubstrats.

Bevorzugt ist es vorgesehen, dass eine gedacht geradlinige erste Verbindungslinie, die durch die erste Kante und die zweite Kante verläuft, gegenüber einer Anbindungsfläche, über die die Metallschicht an die Isolationsschicht angebunden ist, um einen ersten Winkel geneigt ist, und wobei eine erste geradlinige zweite Verbindungslinie, die durch die zweite Kante und das lokale Maximum verläuft, gegenüber der Anbindungsfläche um einen zweiten Winkel geneigt ist, wobei ein Verhältnis des zweiten Winkels zum ersten Winkel kleiner ist als 0,8, bevorzugt kleiner als 0,7 und besonders bevorzugt kleiner als 0,6. Dies gilt bevorzugt für Trägersubstrate mit einer vergleichsweise großen ersten Dicke, beispielsweise ersten Dicken zwischen 0,4 und 2,5 mm. In dieser Ausführungsform ist es insbesondere vorgesehen, dass das lokale Maximum sich insbesondere in einem flachen Flankenverlauf innerhalb des ersten Drittels ausbildet. Es hat sich bereits herausgestellt, dass mit einem solchen sehr flachen Flankenverlauf im ersten Drittel (von der zweiten Kante aus gesehen) mit einem nicht wesentlich ausgeprägten lokalen Maximum bereits signifikante Verbesserungen der Temperaturwechselbeständigkeit erzielen lassen. Außerdem lässt sich ein solcher Verlauf vergleichsweise einfach mit einem Füllmaterial bzw. mit einem Vergussmaterial abdecken. Für Trägersubstrate mit einer vergleichsweise kleinen ersten Dicke ist es bevorzugt vorgesehen, dass der zweite Winkel größer ist als der erste Winkel. Beispielsweise nimmt das Verhältnis des zweiten Winkels zum ersten Winkel einen Wert zwischen 1 und 2,5, bevorzugt zwischen 1,2 und 2 oder besonders bevorzugt von etwa 1,4 und 1,8 an. Es ist auch vorstellbar, dass statt des lokalen Maximums ein Punkt an der Außenseite des Flankenverlaufs genommen wird, der in Primärrichtung gesehen das 2/5-fache der ersten Länge von der zweiten Kante entfernt ist.

Vorzugsweise ist es vorgesehen, dass der zweite Winkel kleiner ist als der erste Winkel bzw. der erste Winkel ist größer als der zweite Winkel. Ein solches Verhältnis zwischen dem ersten Winkel und dem zweiten Winkel hat sich besonders vorteilhaft für Trägersubstrate mit einer vergleichsweise großen ersten Dicke herausgestellt. Vorzugsweise ist die erste Dicke hierbei größer als 300 µm, bevorzugt größer als 400 µm und besonders bevorzugt größer als 500 µm oder sogar größer als 1 mm. Beispielsweise nimmt die erste Dicke einen Wert zwischen 300 µm und 5 mm, bevorzugt zwischen 400 µm und 3 mm und besonders bevorzugt zwischen 500µm und 1 mm an.

Vorzugsweise verändert sich das Verhältnis zwischen dem ersten Winkel und dem zweiten Winkel entlang einer parallel zur Haupterstreckungsebene verlaufenden Umlaufrichtung, insbesondere ist das Verhältnis moduliert, beispielsweise periodisch. Dabei ist es vorstellbar, dass sich das Verhältnis zwischen dem ersten Winkel und dem zweiten Winkel zumindest abschnittsweise auch umkehrt, d. h. es gibt Abschnitte, in denen der erste Winkel größer ist als der zweite Winkel und Abschnitte, in denen der zweite Winkel größer ist als der erste Winkel.

In einer bevorzugten Ausführungsform ist es vorgesehen, dass ein Verhältnis zwischen der zweiten Dicke und der ersten Länge einen Wert zwischen 0,08 und 0,4, bevorzugt zwischen 0,09 und 0,35, und besonders bevorzugt zwischen 0,1 und 0,3 oder sogar 0,1 annimmt, insbesondere wenn der zweite Winkel kleiner ist als der erste Winkel. Besonders für die Werte zwischen 0,1 und 0,3 hat sich eine signifikante Verbesserung der Temperaturwechselbeständigkeit eingestellt, die die Lebensdauer der Trägersubstrate deutlich verlängert.

In einer weiteren Ausführungsform der vorliegenden Erfindung ist es vorgesehen, dass die Metallschicht im lokalen Minimum eine dritte Dicke aufweist, wobei ein Verhältnis der dritten Dicke zur zweiten Dicke einen Wert zwischen 0,1 und 1, bevorzugt zwischen 0,2 und 0,9 und besonders bevorzugt zwischen 0,3 und 0,8 annimmt. Es hat sich als besonders vorteilhaft erwiesen, wenn das lokale Minimum eine deutlich kleinere Dicke aufweist als das lokale Maximum, wonach beispielsweise das Vergussmaterial bzw. Füllmaterial in diese Absenkungen im Bereich des lokalen Minimums eindringen kann und so beispielsweise zu einem zusätzlichen Formschluss in Primärrichtung gesehen führt. Dabei kann sich das Verhältnis der dritten Dicke zur zweiten Dicke in Umlaufrichtung gesehen ändern. Insbesondere könnte das Verhältnis zwischen der dritten Dicke und der zweiten Dicke in Umlaufrichtung periodisch moduliert sein.

In einer besonders bevorzugten Ausführungsform ist es vorgesehen, dass die Metallschicht eine erste Dicke zwischen 0,2 und 1 mm, bevorzugt zwischen 0,25 und 0,8 mm, und besonders bevorzugt zwischen 0,3 und 0,6 mm oder zwischen 0,4 und 2,5 mm, bevorzugt zwischen 0,5 und 2 mm, und besonders bevorzugt zwischen 0,6 und 1,5 mm aufweist. Es hat sich in vorteilhafter Weise herausgestellt, dass der Flankenverlauf mit dem lokalen Maximum und dem lokalen Minimum sich vorteilhaft auf die Temperaturwechselbeständigkeit auswirkt, sowohl für die Trägersubstrate mit der einer üblichen ersten Dicke sowie für eine erste Dicke, die vergleichsweise groß ist. Vorzugsweise ist die erste Dicke größer als 1 mm, bevorzugt größer als 1,5 mm und besonders bevorzugt größer als 2 mm. Insbesondere für das Trägersubstrat mit einer vergleichsweise großen ersten Dicke ist es vorgesehen, dass die Isolationsschicht, d. h. insbesondere die Keramikschicht, eine Dicke aufnimmt, die kleiner ist als 1 mm, bevorzugt kleiner als 0,8 mm, und besonders bevorzugt kleiner als 0,6 mm. Dadurch lässt sich zusätzlich noch die Temperaturleitfähigkeit des Trägersubstrats optimieren.

Ein weiterer Aspekt der vorliegenden Erfindung betrifft eine Großkarte, die mehrere durch mindestens eine Sollbruchlinie voneinander getrennte Trägersubstrate umfasst, wobei sich die Sollbruchlinie benachbart und entlang des Flankenverlaufs mit dem lokalen Maximum und dem lokalen Minimum, insbesondere entlang dessen zweiten Kante, erstreckt. Entlang der Sollbruchlinie werden die einzelnen Trägersubstrate im Fertigungsprozess durch Brechen vereinzelt. Vorzugsweise verläuft die Sollbruchlinie entlang des Flankenverlaufs der weiteren Metallschicht, d. h. der die der Metallschicht bezogen auf die Isolationsschicht in einer senkrecht zur Haupterstreckungsebene verlaufenden Stapelrichtung gegenüberliegt. Es hat sich herausgestellt, dass sich der Flankenverlauf mit dem lokalen Maximum und dem lokalen Minimum in vorteilhafter Weise positiv auf das Bruchverhalten der Großkarte beim Trennen der einzelnen Trägersubstrate auswirkt. Insbesondere wird die Wahrscheinlichkeit für einen Schaden beim Vereinzeln der Trägersubstrate reduziert und so der Ausschluss an unbrauchbaren Trägersubstraten gemindert. Dabei ist es insbesondere vorgesehen, dass sich im Flankenverlauf die Menge des Metalls je Volumeneinheit (spezifische Metallmenge) gegenüber dem zentralen Bereich der Metallschicht mit der Nutzfläche auf 10 bis 80 % reduziert, bevorzugt auf 10 bis 60% und besonders bevorzugt auf 10 bis 40%. Vorzugsweise weist der Flankenverlauf, insbesondere die zweite Kante, beispielsweise der weiteren Metallschicht bzw. der Rückseitenmetallisierung, einen in Primärrichtung gemessener Abstand zur Sollbruchlinie auf, der kleiner ist als 1 mm, bevorzugt einen Abstand zwischen 0,05 und 1 mm aufweist. Vorzugsweise nimmt ein Verhältnis eines in Primärrichtung gemessenen Abstands zwischen der zweiten Kante und der Sollbruchlinie und der ersten Länge einen Wert zwischen 0,15 und 2,0, bevorzugt zwischen 0,2 und 1,6 und besonders bevorzugt zwischen 0,3 und 1,2 an. Dies gilt insbesondere für vergleichsweise dicke ersten Dicken, d. h. erste Dicken zwischen 0,4 und 2,5 mm. Bevorzugt ist es vorgesehen, dass der in Primärrichtung gemessene Abstand zwischen der zweiten Kante und der Sollbruchlinie kleiner ist als die erste Länge. Weiterhin ist es vorgesehen, dass zur Trennung der einzelnen Trägersubstraten zwei Gruppen von Sollbruchlinien vorgesehen, die sich kreuzen und vorzugsweise senkrecht zueinander verlaufen.

Vorzugsweise ist das Trägersubstrat, insbesondere zusammen mit einem ersten elektrischen Bauteil, in eine Verkapselung eingebettet. Insbesondere zusammen mit dem geschwungenen Ätzkantenverlauf lässt sich das Trägersubstrat besonders wirksam mit der Verkapselung einbetten, und bildet einen wirksamen Formschluss bzw. eine Verankerung aus. Dies trifft insbesondere bei den Ätzkantenverläufen zu, bei denen der zweite Winkel größer als der erste Winkel ist. Dabei ist die Verkapselung vorzugsweise massiv, so dass sich keine Hohlräume zwischen der Verkapselung und dem Trägersubstrat ausbilden. Dadurch lässt sich mit Vorteil ein besonders kompaktes Elektronikmodul realisieren, dessen Trägersubstrat vorteilhafter Weise schlaggeschützt ist.

Weiterhin ist es bevorzugt vorgesehen, dass an der Außenseite der Verkapselung ein zweites elektrisches Bauteil vorgesehen ist, wobei vorzugsweise das erste elektrische Bauteil über eine durch die Verkapselung verlaufende Durchkontaktierung mit dem ersten elektrischen Bauteil verbunden ist. Beispielsweise ist es dabei vorgesehen, dass eine Durchkontaktierung im gefertigten Zustand einen Kontakt zu einen Anschluss an einer Oberseite des ersten elektrischen Bauteils herstellt, d. h. einer Seite, die im montierten Zustand in Stapelrichtung dem Trägersubstrat gegenüberliegt. Weiterhin ist es bevorzugt vorgesehen, dass an der Außenseite der Verkapselung eine weitere Metallisierung, insbesondere strukturierte Metallisierung, vorgesehen ist, die ein einfaches Anschließen des zweiten elektrischen bzw. elektronischen Bauteils gestattet.

Ein weiterer Aspekt der Erfindung betrifft ein Verfahren zur Herstellung eines Trägersubstrats gemäß einem der vorhergehenden Ansprüche, wobei der Flankenverlauf bevorzugt durch ein Ätzschritt, insbesondere einen einzigen Ätzschritt hergestellt wird. Alle für das Trägersubstrat beschriebenen Merkmale und deren Vorteile lassen sich analog auf das Verfahren übertragen und andersrum.

Hierzu wird vorzugsweise die Metallschicht an die Isolierschicht mittels eines AMB-Verfahrens und/oder ein DCB-Verfahren stoffschlüssig angebunden.

Unter einem "DCB-Verfahren" (Direct-Copper-Bond-Technology) oder einem "DAB-Verfahren" (Direct-Aluminium-Bond-Technology) versteht der Fachmann ein solches Verfahren, das beispielsweise zum Verbinden von Metallschichten oder - blechen (z. B. Kupferblechen oder -folien oder Aluminiumblechen oder -folien) miteinander und/oder mit Keramik oder Keramikschichten dient, und zwar unter Verwendung von Metall- bzw. Kupferblechen oder Metall- bzw. Kupferfolien, die an ihren Oberflächenseiten eine Schicht oder einen Überzug (Aufschmelzschicht), aufweisen. Bei diesem beispielsweise in der US 3 744 120 A oder in der DE23 19 854 C2 beschriebenen Verfahren bildet diese Schicht oder dieser Überzug (Aufschmelzschicht) ein Eutektikum mit einer Schmelztemperatur unter der Schmelztemperatur des Metalls (z. B. Kupfers), so dass durch Auflegen der Folie auf die Keramik und durch Erhitzen sämtlicher Schichten diese miteinander verbunden werden können, und zwar durch Aufschmelzen des Metalls bzw. Kupfers im Wesentlichen nur im Bereich der Aufschmelzschicht bzw. Oxidschicht.

Insbesondere weist das DCB-Verfahren dann z. B. folgende Verfahrensschritte auf:
- Oxidieren einer Kupferfolie derart, dass sich eine gleichmäßige Kupferoxidschicht ergibt;
- Auflegen des Kupferfolie auf die Keramikschicht;
- Erhitzen des Verbundes auf eine Prozesstemperatur zwischen etwa 1025 bis 1083°C, z. B. auf ca. 1071 °C;
- Abkühlen auf Raumtemperatur.

Unter einem Aktivlot-Verfahren z. B. zum Verbinden von Metallschichten oder Metallfolien, insbesondere auch von Kupferschichten oder Kupferfolien mit Keramikmaterial ist ein Verfahren zu verstehen, welches speziell auch zum Herstellen von Metall-Keramik-Substraten verwendet wird, wird bei einer Temperatur zwischen ca.650-1000°C eine Verbindung zwischen einer Metallfolie, beispielsweise Kupferfolie, und einem Keramiksubstrat, beispielsweise Aluminiumnitrid-Keramik, unter Verwendung eines Hartlots hergestellt, welches zusätzlich zu einer Hauptkomponente wie Kupfer, Silber und/oder Gold auch ein Aktivmetall enthält. Dieses Aktivmetall, welches beispielsweise wenigstens ein Element der Gruppe Hf, Ti, Zr, Nb, Ce ist, stellt durch chemische Reaktion eine Verbindung zwischen dem Lot und der Keramik her, während die Verbindung zwischen dem Lot und dem Metall eine metallische Hartlöt-Verbindung ist. Alternativ ist zur Anbindung auch ein Dickschichtverfahren vorstellbar.
Bevorzugt ist es vorgesehen, dass die Metallschicht mittels eines DCB-Verfahrens oder einem DAB-Verfahren an die Isolationsschicht angebunden wird. Es hat sich überraschender Weise herausgestellt, dass eine besonders große Verbesserung in Hinblick auf die Temperaturwechselbeständigkeit erzielen lässt, wenn die Metallschicht mittels eine DCB-Verfahrens an die Isolationsschicht angebunden wird.

Der Ausdruck im Wesentlichen bedeutet im Sinne der Erfindung Abweichungen vom jeweils exakten Wert um +/- 15 %, bevorzugt um +/- 10 % und besonders bevorzugt um +/- 5 % und/oder Abweichungen in Form von für die Funktion unbedeutenden Änderungen.

Weitere Vorteile und Merkmale ergeben sich aus der nachfolgenden Beschreibung bevorzugter Ausführungsformen des erfindungsgemäßen Gegenstands mit Bezug auf die beigefügten Figuren. Einzelne Merkmale der einzelnen Ausführungsformen können dabei im Rahmen der Erfindung miteinander kombiniert werden.

Es zeigt:
- **Fig.1:**: schematische Darstellung eines Trägersubstrats gemäß einer ersten bevorzugten Ausführungsform der vorliegenden Erfindung,
- **Fig. 2**: schematische Darstellung eines Trägersubstrats gemäß einer zweiten bevorzugten Ausführungsform der vorliegenden Erfindung,
- **Fig. 3**: schematische Darstellung eines Trägersubstrats gemäß einer dritten bevorzugten Ausführungsform der vorliegenden Erfindung
- **Fig. 4**: schematische Darstellung eines Trägersubstrats gemäß einer vierten bevorzugten Ausführungsform der vorliegenden Erfindung,
- **Fig. 5**: graphische Darstellung von Messergebnissen zur Temperaturwechselbeständigkeit und
- **Fig. 6**: Großkarte mit Sollbruchstelle, in Schnittansicht

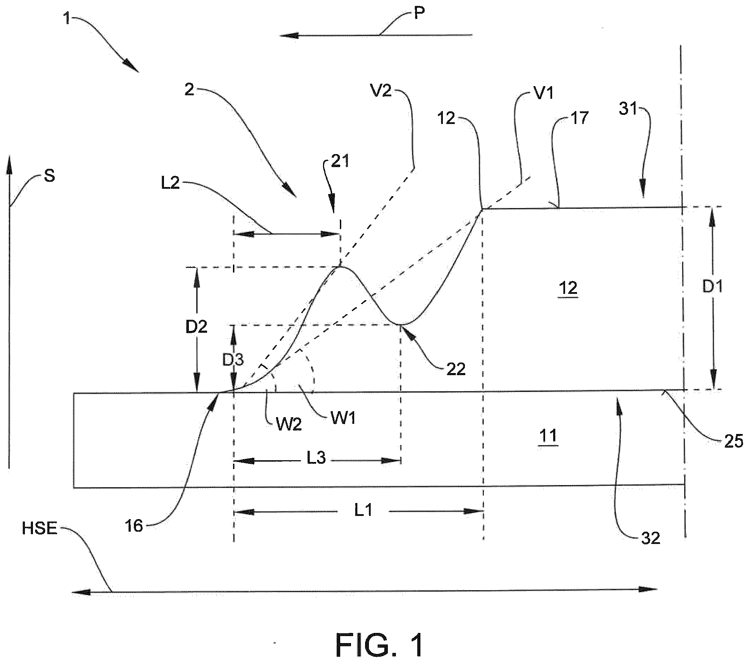

In **Figur 1** ist ein Trägersubstrat 1 gemäß einer ersten bevorzugten Ausführungsform der vorliegenden Erfindung dargestellt. Solche Trägersubstrate 1 dienen vorzugsweise als Träger von elektronischen bzw. elektrischen Bauteile, die an das Trägersubstrat 1 anbindbar sind. Wesentliche Bestandteile eines solchen Trägersubstrats 1 sind eine sich entlang einer Haupterstreckungsebene HSE erstreckende Isolationsschicht 11 und eine an der Isolationsschicht 11 angebundene Metallschicht 12. Die Isolationsschicht 11 ist aus mindestens einem eine Keramik umfassenden Material gefertigt. Die Metallschicht 12 und die Isolationsschicht 11 sind dabei entlang einer senkrecht zur Haupterstreckungsebene HSE verlaufenden Stapelrichtung S übereinander angeordnet und über eine Anbindungsfläche 25 miteinander stoffschlüssig verbunden. Im gefertigten Zustand ist die Metallschicht 12 zur Bildung von Leiterbahnen oder Anbindungsstellen für die elektrischen Bauteile strukturiert. Beispielsweise wird diese Strukturierung in die Metallschicht 12 eingeätzt. Im Vorfeld muss allerdings eine dauerhafte Bindung, insbesondere stoffschlüssige Anbindung, zwischen der Metallschicht 12 und der Isolationsschicht 11 gebildet werden.

Um die Metallschicht 12 dauerhaft an die Isolationsschicht 11 anzubinden, umfasst eine Anlage zur Herstellung des Trägersubstrats, insbesondere in einem SFB (Super - Flat - Bonding) -Anbindungsverfahren, beispielsweise einen Ofen, in dem ein bereitgestellter Vorverbund aus Metall und Keramik erhitzt wird und so die Bindung erzielt wird. Beispielsweise handelt es sich bei der Metallschicht 12 um eine aus Kupfer gefertigte Metallschicht 12, wobei die Metallschicht 12 und die Isolationsschicht 11 mittels eines DCB (Direct-Copper-Bonding)-Anbindungsverfahren miteinander stoffschlüssig verbunden werden. Alternativ lässt sich die Metallschicht 12 an die Keramikschicht 11 über ein Aktivlötverfahren anbinden. Insbesondere weist die Metallschicht 12 eine der Keramikschicht 11 abgewandte Oberseite 31 und eine der Keramikschicht 11 zugewandte Unterseite 32 auf. Die Oberseite 31 der Metallschicht 12 umfasst dabei eine Nutzfläche 17, auf der insbesondere elektrische oder elektronische Bauteile montierbar sind. Die Oberseite 31 wird in eine parallel zur Haupterstreckungsebene HSE verlaufende Richtung durch eine erste Kante 15 begrenzt, während die Unterseite 32 der Metallschicht 12 über die Anbindungsfläche 25 stoffschlüssig mit der Keramikschicht 11 verbunden ist. Die Anbindungsfläche 25 wird in einer parallel zur Haupterstreckungsebene HSE verlaufenden Richtung durch eine zweite Kante 16 nach außen hin begrenzt. Dabei liegen die erste Kante 15 und die zweite Kante 16 in einer senkrecht zur Haupterstreckungsebene HSE verlaufenden Stapelrichtung S gesehen nicht deckungsgleich übereinander, sondern sind entlang einer Primärrichtung P zueinander versetzt. Die Primärrichtung P verläuft insbesondere von einem Zentralbereich der Metallschicht 12, in dem beispielsweise die Nutzfläche 17 vorgesehen ist, nach außen zu einem Bereich des Trägersubstrats 1, der metallfrei ist, d. h. einem Bereich, in dem im Wesentlichen die Keramikschicht die Außenseite des Trägersubstrats bildet. Die erste Kante 15 wird mit der zweiten Kante 16 durch einen sich entlang der Primärrichtung P erstreckenden Flankenverlauf 2 verbunden. Beispielsweise wird der Flankenverlauf 2 durch einen Ätzprozess, insbesondere durch einen einmaligen Ätzschritt, hergestellt. Der Flankenverlauf 2 bildet im Bereich zwischen der ersten Kante 15 und der zweiten Kante 16 insbesondere in einem senkrecht zur Haupterstreckungsebene HSE verlaufenden Querschnitt betrachtet die Außenseite der Metallschicht 12.

Zur Verbesserung der Temperaturwechselbeständigkeit ist es insbesondere vorgesehen, dass der Flankenverlauf 2 zwischen der ersten Kante 15 und der zweiten Kante 16 mindestens ein lokales Maximum 21 und mindestens eine lokales Minimum 22 aufweist. Dabei liegt das lokale Minimum 22 in Primärrichtung P gesehen vorzugsweise zwischen der erste Kante 15 und dem lokalen Maximum 21.

Insbesondere ist es vorgesehen, dass die Metallschicht 12 im Zentralbereich, das heißt insbesondere im Bereich der Nutzfläche 17, eine erste Dicke D1 und im lokalen Maximum 21 eine zweite Dicke D2 aufweist, wobei die erste Dicke D1 größer als die zweite Dicke D2 ist. Vorzugsweise nimmt ein Verhältnis der zweiten Dicke D2 zu der ersten Dicke D1 einen Wert zwischen 0,5 und 0,9, bevorzugt zwischen 0,6 und 0,9, und besonders bevorzugt zwischen 0,7 und 0,9 an. Mit anderen Worten: der Flankenverlauf 2 weist eine zusätzliche Auswölbung oder Erhebung, beispielsweise in Form einer hügel- oder wulstartigen Erhebung, zwischen der ersten Kante 15 und der zweiten Kante 16 der Metallschicht 12 auf, wobei das lokale Maximum 21 kleiner ist als ein globale Maximum, das beispielsweise durch die erste Dicke D1 der Metallschicht 12 festgelegt ist. Weiterhin ist es vorgesehen, dass sich der Flankenverlauf 2 in Primärrichtung P gemessen über eine erste Länge L1 erstreckt, wobei ein Verhältnis zwischen der ersten Länge L1 zur ersten Dicke D1 einen Wert zwischen 0,5 und 1,9, bevorzugt zwischen 0,6 und 1,7 und besonders bevorzugt zwischen 0,7 und 1,5 annimmt.

Besonders bevorzugt ist es, wenn die Metallschicht 12 im lokalen Minimum 22 eine dritte Dicke D3 aufweist, wobei ein Verhältnis der dritten Dicke D3 zur zweiten Dicke D2 einen Wert zwischen 0,1 und 1, bevorzugt zwischen 0,2 und 0,8 und besonders bevorzugt zwischen 0,3 und 0,6 annimmt. In Figur 1 sind des Weiteren eine gedachte geradlinige erste Verbindungslinie V1 und eine gedachte geradlinige zweite Verbindungslinie V2 eingezeichnet. Die erste Verbindungslinie V1 durchläuft die erste Kante 15 und die zweite Kante 16 und ist gegenüber der Anbindungsfläche 25 um einen ersten Winkel W1 geneigt, während die zweite Verbindungslinie V2 durch die zweite Kante 16 und das lokale Maximum 21 verläuft. Dabei ist die zweite Verbindungslinie V2 gegenüber der Anbindungsfläche 25 um einen zweiten Winkel W2 geneigt. Vorzugsweise ist es vorgesehen, dass der zweite Winkel W2 größer ist als der erste Winkel W1. Beispielsweise nimmt das Verhältnis des zweiten Winkels W2 zum ersten Winkel W1 einen Wert zwischen 1 und 2,5, bevorzugt zwischen 4- 1,2 und 2 oder besonders bevorzugt von etwa 1,4 und 1,8 an. Ferner ist es vorgesehen, dass sich der Flankenverlauf 2 von der zweiten Kante 16 an der Unterseite 32 bis zum lokalen Maximum 21 über eine zweite Länge L2 erstreckt, wobei eine Verhältnis zwischen der zweiten Länge L2 zur ersten Länge L1 eine Wert zwischen 0,2 und 0,7, bevorzugt zwischen 0,25 und 0,6, und besonders bevorzugt zwischen 0,3 und 0,5 annimmt. Vorzugsweise ist es vorgesehen, dass ein Verhältnis zwischen der zweiten Dicke D2 zur ersten Länge L1 einen Wert zwischen 0,085 und 0,4, bevorzugt zwischen 0,09 und 0,35 und besonders bevorzugt zwischen 0,1 und 0,3 oder sogar 0,11 annimmt.

In dem dargestellten Ausführungsbeispiel der Figur 1 ist zudem die erste Dicke D1 zwischen 0,2 und 1 mm dick, bevorzugt zwischen 0,25 und 0,8 mm, und besonders bevorzugt zwischen 0,3 und 0,6 mm.

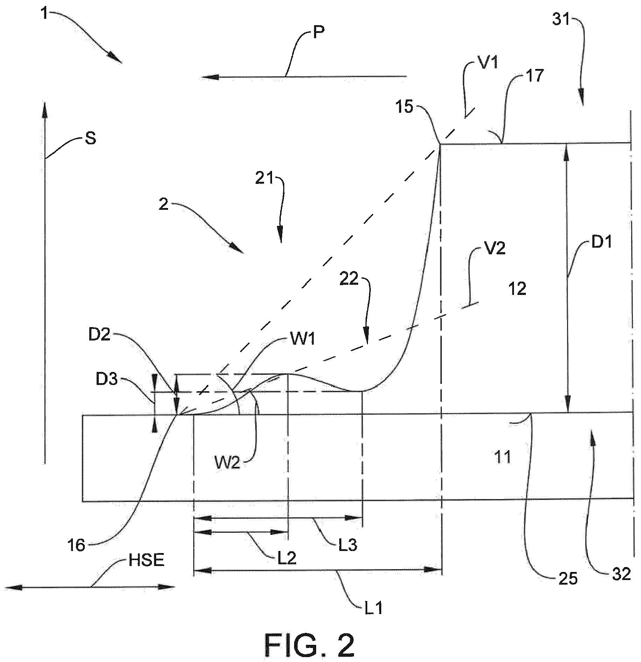

In **Figur 2** ist schematisch ein Trägersubstrat 1 gemäß einer zweiten bevorzugten Ausführungsform der vorliegenden Erfindung dargestellt. Dabei entspricht die Ausführungsform im Wesentlichen derjenigen aus Figur 1 und unterscheidet sich nur dahingehend, dass die erste Dicke D1 einen Wert zwischen 0,4 und 2,5 mm, bevorzugt zwischen 0,5 und 2 mm, und besonders bevorzugt zwischen 0,6 und 1,5 mm aufweist. Mit anderen Worten: gegenüber der Ausführungsform aus Figur 1 handelt es sich hier um eine vergleichsweise dicke Metallschicht 12 im Zentralbereich. Vorzugsweise nimmt ein Verhältnis der zweiten Dicke D2 zu der ersten Dicke D1 hier einen Wert zwischen 0,01 und 0,5, bevorzugt zwischen 0,05 und 0,4, und besonders bevorzugt zwischen 0,01 und 0,3 an. Vorzugsweise ist es vorgesehen, dass ein Verhältnis des zweiten Winkels W2 zum ersten Winkel W1 kleiner als 0,8, bevorzugt kleiner als 0,7, und besonders bevorzugt kleiner als 0,6 ist.

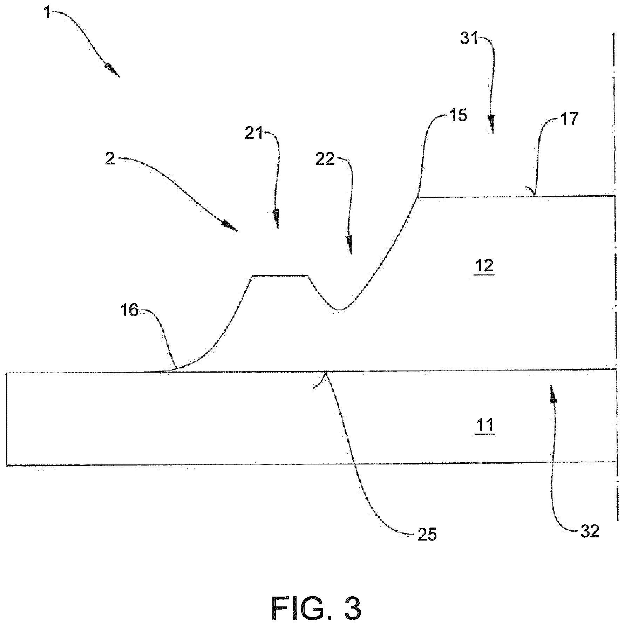

In **Figur 3** ist schematisch ein Trägersubstrat gemäß 1 einer dritten bevorzugten Ausführungsform der vorliegenden Erfindung dargestellt. Dabei entspricht die Ausführungsform im Wesentlichen derjenigen aus der Figur 1 und unterscheidet sich nur dahingehend von der dort gezeigten Ausführungsform, dass hier statt eines kuppelförmigen lokalen Maximums 21 ein plateauförmiges lokales Maximum 21 ausgebildet ist.

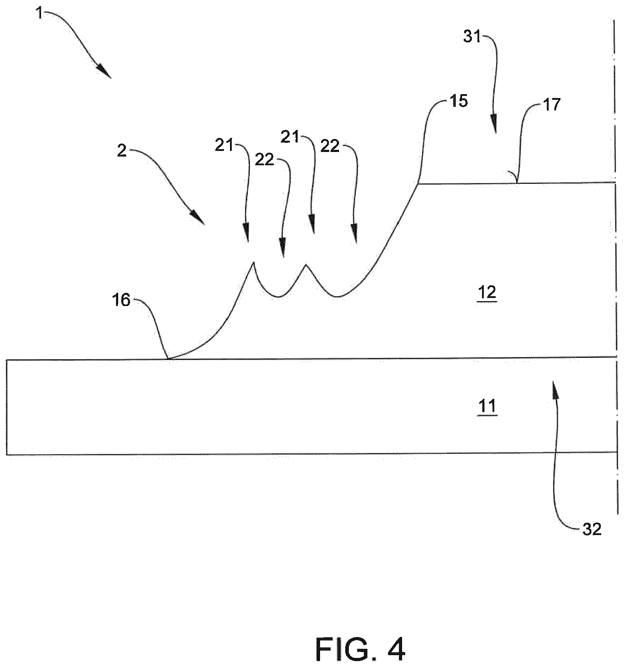

In **Figur** 4 ist schematisch ein Trägersubstrat 1 gemäß einer vierten bevorzugten Ausführungsform der vorliegenden Erfindung dargestellt, wobei der Flankenverlauf 2 mehrere lokale Maxima 21 und mehrere lokale Minima 22 aufweist. Dabei weist die Metallschicht 12 in den jeweiligen lokalen Maxima 21 und lokalen Minima 22 jeweils dieselbe Dicke auf. Es ist allerdings auch vorstellbar, dass die Metallschicht 12 in den unterschiedlichen lokalen Maxima 21 und/oder lokalen Minima 22 unterschiedliche Dicken aufweist.

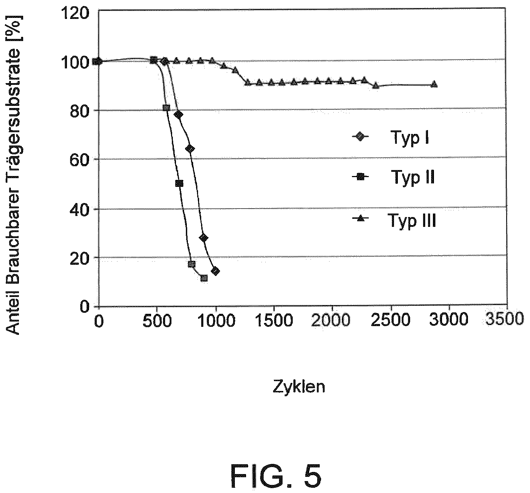

Die **Figur 5** zeigt graphisch die Ergebnisse von Messungen zur Temperaturwechselbeständigkeit. Insbesondere ist hier die jeweilige Anzahl an Temperaturzyklen gegen den prozentualen Anteil an noch brauchbaren Trägersubstraten 1 aufgetragen. Die folgenden Untersuchungen zur Temperaturwechselbeständigkeit wurden an Trägersubstraten 1 aus einer Isolationsschicht 11, einer Metallschicht 12 und einer weiteren Metallschicht 12 (wobei die Isolationsschicht 11 zwischen der Metallschicht 12 und der weiteren Metallschicht 12 angeordnet ist) vorgenommen, die eine
- Isolationsschicht 11 aus einer HPS9 mit einer Isolationsschichtdicke ID von 0,32 mm bzw. 0,25 mm und
- eine Metallschicht 12 und eine weitere Metallschicht 12 jeweils aus einer 0,3 mm Kupferschicht
aufweisen. Hierzu wurden die Untersuchungen zur Temperaturwechselbeständigkeit zwischen -55 °C und + 150°C durchgeführt. Innerhalb eines Zyklus wird dabei das jeweilige Trägersubstrat 1 einer Temperaturschwankung zwischen - 55 ° und + 150 ° ausgesetzt und so die Anzahl der Zykluszahl, nach der eine Delimination bzw. ein Einreißen der Isolationsschicht 11 bzw. der Metallschicht 12 festgestellt wird, (beispielsweise mittels eines Ultraschallbildgebungsverfahren oder durch Inaugenscheinnahme) erfasst. Die durchschnittliche Zykluszahl, nach der die Trägersubstrate 1 noch brauchbar waren bzw. keine Delimination zeigen, ist somit Maß für die Temperaturwechselbeständigkeit des Trägersubstrats 1. Die Untersuchungen zur Temperaturwechselbeständigkeit wurden durchgeführt für
- ein Trägersubstrat Typ I, das eine Isolationsschichtdicke von 0,25 mm, eine Materialschwächung in Form einer kuppelförmigen Aussparung im Randbereich, einen geschwungenen Flankenverlauf und kein Flankenverlauf mit einem lokalen Maximum 21 und einem lokalen Minimum 22 aufweist,
- ein Trägersubstrat Typ II, das eine Isolationsschichtdicke von 0,32 mm, eine Materialschwächung in Form einer kuppelförmigen Aussparung im Randbereich, einen geschwungener Flankenverlauf 2 und kein Flankenverlauf 2 mit einem lokalen Maximum 21 und einem lokalen Minimum 22 aufweist und
- ein Trägersubstrat Typ III, das eine Isolationsschichtdicke von 0,32 mm, eine Materialschwächung in Form einer kuppelförmigen Aussparung im Randbereich und einen Flankenverlauf 2 mit einem lokalen Maximum 21 und einem lokalen Minimum 22 aufweist.

Für das Trägersubstrat Typ I zeigte sich, dass der prozentuale Anteil an gebrauchsfähigen Trägersubstraten nach etwa 800 thermischen Zyklen abnimmt.

Für das Trägersubstrat Typ II zeigte sich, dass der prozentuale Anteil an gebrauchsfähigen Trägersubstraten nach etwa 700 thermischen Zyklen abnimmt.

Für das Trägersubstrat Typ III zeigte sich, dass erst nach mehr als 1000 Zyklen der prozentuale Anteil an brauchbaren Trägersubstraten sank und bei mehr als 2000 Zyklen noch deutlich oberhalb von 80 % lag.

Den Versuchen sind demnach folgende Ergebnisse zu entnehmen:
Der Flankenverlauf 2 mit dem lokalen Maximum 21 und dem lokalem Minimum 22 führt zu einer signifikanten Verbesserung der Temperaturwechselbeständigkeit gegenüber der bisherigen Verbesserungsmethode, bei der in den Randbereich kuppelförmige Aussparungen eingelassen sind.

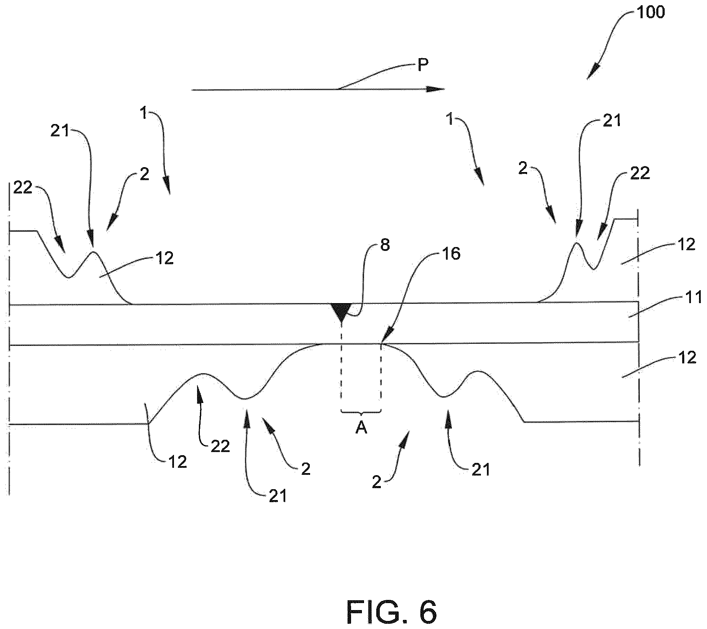

In **Figur 6** ist eine Großkarte 100 mit einer Sollbruchstelle 8 dargestellt. Vorzugsweise umfasst eine solche Großkarte 100 mehrere Trägersubstrate 1, die zur Vereinzelung entlang der Sollbruchstelle 8 voneinander getrennt werden. Es hat sich dabei als vorteilhaft für ein Bruchverhalten der Großkarte 100 herausgestellt, wenn sich die Sollbruchstelle 8 zumindest bereichsweise benachbart zum Flankenverlauf 2 mit dem lokalen Maximum 21 und dem lokalen Minimum 22 erstreckt. Insbesondere ist es vorgesehen, dass von der Sollbruchlinie 8 ausgehend in Primärrichtung P gesehen, die Metallschicht 12 bzw. die weitere Metallschicht 12 mit jeweils einem Flankenverlauf 2 beginnen. Es hat sich insbesondere als vorteilhaft herausgestellt, wenn ein Abstand A zwischen der zweiten Kante 16 und der Sollbruchstelle 8, insbesondere einer Mitte der Sollbruchstelle 8, kleiner als 1 mm ist. Insbesondere nimmt ein Verhältnis des Abstands A zu der ersten Länge L1 einen Wert zwischen 0,0 und 1,5 an. Besonders bevorzugt ist es vorgesehen, dass die Sollbruchstelle 8 auf der Seite der Metallschicht 12 eingelassen ist und der Abstand A des Flankenverlaufs 2 zur weiteren Metallschicht 12 (auf der gegenüberliegenden Seite der Isolationsschicht 11) kleiner ist als der Abstand A zwischen der Metallschicht 12 und der Sollbruchstelle 8. Insbesondere ist es vorstellbar, dass sich die weitere Metallschicht12 möglichst weit in Richtung der Sollbruchstelle 8 erstreckt, um als Rückseitenmetallisierung, die Isolationsschicht 11 zu stabilisieren, insbesondere wenn die Isolationsschicht 11 vergleichsweise dünn, d. h. dünner als 1 mm, vorzugsweise dünner als 0,8 mm, ausgestaltet ist. In der dargestellten Ausführungsform weisen alle Metallschichten 12 einen Flankenverlauf 2 mit einem ersten Maximum 21 und einem Minimum 22 auf. Es ist auch vorstellbar, dass die Metallschicht 12 oder die weitere Metallschicht 12 statt eines Flankenverlaufs 2 mit einem lokalen Maximum 21 oder lokalen Minimum 22 einen schrägen oder gebogenen Flankenverlauf 2 aufweisen oder einen Randbereich mit einer Materialschwächung, wie es in EP 1 061 783 A2 offenbart ist, auf dessen Inhalt diesbezüglich explizit Bezug genommen wird. Dabei ist zumindest eine der Metallschichten 12 an der Isolationsschicht 11 mit einem Flankenverlauf 2 mit einem lokalen Maximum 12 und einem lokalen Minimum 22 ausgestaltet.

Vorzugsweise weist die Isolationsschicht 11 eine Dicke von weniger als 0,25 mm und besonders bevorzugt weniger als 0,2 mm auf. Bei derartig dünnen Isolationsschichten ist eine Rückseitenmetallisierung erforderlich.

### Bezugszeichenliste:

- 1: Trägersubstrat
- 2: Flankenverlauf
- 8: Sollbruchstelle
- 11: Isolationsschicht
- 12: Metallschicht
- 15: erste Kante
- 16: zweite Kante
- 17: Nutzfläche
- 21: lokales Maximum
- 22: lokales Minimum
- 25: Anbindungsfläche
- 31: Oberseite
- 32: Unterseite
- 100: Großkarte
- D1: erste Dicke
- D2: zweite Dicke
- D3: dritte Dicke
- V1: erste Verbindungslinie
- V2: zweite Verbindungslinie
- L1: erste Länge
- L2: zweite Länge
- L3: dritter Länge
- W1: erster Winkel
- W2: zweite Winkel
- S: Stapelrichtung
- HSE: Haupterstreckungsebene
- P: Primärrichtung
- A: Abstand

## Patentansprüche

1. Trägersubstrat (1), umfassend
eine Isolationsschicht (11) und eine Metallschicht (12),
wobei die Metallschicht (12) in einer parallel zur Haupterstreckungsebene (HSE) verlaufenden Primärrichtung (P) zumindest bereichsweise mit einem Flankenverlauf (2), insbesondere Ätzflankenverlauf, abschließt,
wobei sich in Primärrichtung (P) gesehen der Flankenverlauf (2) von einer ersten Kante (15) an einer Oberseite (31) der Metallschicht (12), die der Isolationsschicht (11) abgewandt ist, bis zu einer zweiten Kante (16) an einer Unterseite (32) der Metallschicht (12), die der Isolationsschicht (11) zugewandt ist, erstreckt, **dadurch gekennzeichnet, dass** der Flankenverlauf (2) in Primärrichtung (P) gesehen mindestens ein lokales Maximum (21) und mindestens ein lokales Minimum (22) aufweist und die Metallschicht (12) an die Isolierschicht (11) mittels eines DCB-Verfahrens stoffschlüssig angebunden ist.

2. Trägersubstrat (1) gemäß Anspruch 1, wobei die Metallschicht (12) außerhalb des Flankenverlaufs (2), insbesondere in einem als Nutzfläche (17) vorgesehenen zentralen Bereich, eine erste Dicke (D1) und im lokalen Maximum (21) eine zweite Dicke (D2) aufweist, wobei die zweite Dicke (D2) kleiner ist als die erste Dicke (D1).

3. Trägersubstrat (1) gemäß Anspruch 2, wobei ein Verhältnis der zweiten Dicke (D2) zur ersten Dicke (D1) kleiner als 0,95, bevorzugt kleiner als 0,9 und besonders bevorzugt kleiner als 0,8 ist.

4. Trägersubstrat (1) gemäß einem der Ansprüche 2 oder 3, wobei sich der Flankenverlauf (2) in Primärrichtung (P) gemessen über eine erste Länge (L1) erstreckt, wobei ein Verhältnis zwischen der ersten Länge (L1) zur ersten Dicke (D1) einen Wert zwischen 0,5 und 1,9, bevorzugt zwischen 0,6 und 1,7 und besonders bevorzugt zwischen 0,7 und 1,5 annimmt.

5. Trägersubstrat (1) gemäß einem der Ansprüche 2 bis 4, wobei sich der Flankenverlauf (2) von der zweiten Kante (16) an der Unterseite (32) bis zum lokalen Maximum (21) über eine zweite Länge (L2) erstreckt, wobei ein Verhältnis zwischen der zweiten Länge (L2) zu der ersten Länge (L1) einen Wert zwischen 0,2 und 0,7, bevorzugt zwischen 0,25 und 0,6 und besonders bevorzugt zwischen 0,3 und 0,5 annimmt.

6. Trägersubstrat (1) gemäß einem der Ansprüche 2 bis 5, wobei eine zweite Dicke (D2) zur ersten Länge (L1) einen Wert zwischen 0,08 und 0,4, bevorzugt zwischen 0,09 und 0,35 und besonders bevorzugt zwischen 0,1 und 0,3 oder sogar 0,1 annimmt.

7. Trägersubstrat (1) gemäß einem der vorhergehenden Ansprüche, wobei eine gedachte geradlinige erste Verbindungslinie (V1), die durch die erste Kante (16) und die zweite Kante (15) verläuft, gegenüber einer Anbindungsfläche (25), über die die Metallschicht (12) an die Isolationsschicht (11) angebunden ist, um einen ersten Winkel (W1) geneigt ist, und wobei eine gedachte geradlinige zweite Verbindungslinie (V2), die durch die zweite Kante (16) und das lokale Maximum (21) verläuft, gegenüber der Anbindungsfläche (25) um einen zweiten Winkel (W2) geneigt ist.

8. Trägersubstrat (1) gemäß Anspruch 7, wobei
der zweite Winkel (W2) kleiner als der erste Winkel (W1) ist und insbesondere ein Verhältnis des zweiten Winkels (W2) zum ersten Winkel (W1) kleiner ist als 0,8, bevorzugt kleiner als 0,7 und besonders bevorzugt kleiner als 0,6 ist.

9. Trägersubstrat gemäß Anspruch 7 oder 8
- der zweite Winkel (W2) größer ist als der erste Winkel (W1) und insbesondere das Verhältnis des zweiten Winkels (W2) zum ersten Winkel (W1) einen Wert zwischen 1 und 2,5, bevorzugt zwischen 1,2 und 2 oder besonders bevorzugt von etwa 1,4 und 1,8 annimmt.

10. Trägersubstrat gemäß Anspruch 8 oder 9, wobei sich das Verhältnis zwischen dem ersten Winkel (W1) und dem zweiten Winkel (W2) entlang einer parallel zur Haupterstreckungsebene (HSE) verlaufenden Umlaufrichtung verändert, insbesondere moduliert ist.

11. Trägersubstrat (1) gemäß einem der Ansprüche 2 bis 10, wobei die Metallschicht (12) im lokalem Minimum (22) eine dritte Dicke (D3) aufweist, wobei ein Verhältnis der dritten Dicke (D3) zur zweiten Dicke (D2) einen Wert zwischen 0,1 und 1, bevorzugt zwischen 0,2 und 0,8 und besonders bevorzugt zwischen 0,3 und 0,6 annimmt.

12. Trägersubstrat (1) gemäß einem der vorhergehenden Ansprüche, wobei die erste Dicke (D1) einen Wert
- zwischen 0,2 und 1,0 mm, bevorzugt zwischen 0,25 und 0,8 mm und besonders bevorzugt zwischen 0,3 und 0,6 mm oder
- zwischen 0,4 und 2,5 mm, bevorzugt zwischen 0,5 und 2 mm und besonders bevorzugt zwischen 0,6 und 1,5 mm
aufweist.

13. Trägersubstrat (1) gemäß einem der vorhergehenden Ansprüche, wobei das Trägersubstrat (1), insbesondere zusammen mit einem ersten elektrischen Bauteil, in eine Verkapselung eingebettet ist.

14. Trägersubstrat (1) gemäß Anspruch 13, wobei an der Außenseite der Verkapselung ein zweites elektrisches Bauteil vorgesehen ist, wobei vorzugsweise das erste elektrische Bauteil über eine durch die Verkapselung verlaufende Durchkontaktierung mit dem ersten elektrischen Bauteil verbunden ist.

15. Verfahren zur Herstellung eines Trägersubstrats (1) gemäß einem der vorhergehenden Ansprüche, wobei der Flankenverlauf (2) bevorzugt durch ein Ätzschritt, insbesondere einen einzigen Ätzschritt, hergestellt wird und die Metallschicht (12) an die Isolierschicht (11) mittels eines DCB-Verfahrens stoffschlüssig angebunden wird.
